# EUROPEAN PATENT SPECIFICATION

(11) **EP 3 968 435 B1**
(45) Date of publication and mention of the grant of the patent: **26.06.2024**
(21) Application number: 20901327.5
(22) Date of filing: 03.12.2020
(51) Int. Cl.: H01M 10/48, H02J 7/00, G01R 31/392, H01M 10/42

(54) **STATE OUTPUT SYSTEM**
ZUSTANDSAUSGABESYSTEM
SYSTÈME DE SORTIE D'ÉTAT

(30) Priority: 17.12.2019 JP 2019227626
(43) Date of publication of application: 16.03.2022
(73) Proprietor: Toyo System Co., Ltd., Iwaki-shi, Fukushima 972-8316 (JP)
(72) Inventor: MUNAKATA, Ichiro, Iwaki-shi, Fukushima 972-8316 (JP); SHOJI, Hideki, Iwaki-shi, Fukushima 972-8316 (JP)
(74) Representative: Schön, Christoph
(86) International application number: PCT/JP2020/045128
(87) International publication number: WO 2021/124914

(56) References cited:
- WO-A1-2012/117874
- WO-A1-2019/131824
- JP-A- 2012 235 551
- JP-A- 2013 221 806
- JP-A- 2015 031 674
- US-A1- 2016 116 547
- US-A1- 2017 350 946

## Description

### Technical Field

The present invention relates to a system for outputting the state of a secondary battery such as a lithium ion battery.

### Background Art

Conventionally, there has been proposed a system for outputting the state of a secondary battery such as a lithium ion battery (see Patent Literature 1).

### Citation List

### Patent Literature

Patent Literature 1: Japanese Patent Application Laid-Open No. 2019-045180

US 2017/350946 A1, US 2016/116547 A1 and WO 2019/131824 A1 disclose systems to output the deterioration state of secondary batteries

### Summary of Invention

### Technical Problem

However, according to the prior art, the deterioration state of the secondary battery is analyzed by a single method. Therefore, since it is inefficient and takes time to do a detailed analysis every time, it may not be able to let a user know the deterioration state of the secondary battery in a timely manner.

On the other hand, when a simplified analysis is performed to let the user know the deterioration state in a timely manner, it cannot meet the needs of the user who wants to know the detailed analysis results of the deterioration state of the secondary battery.

Therefore, it is an object of the present invention to provide a secondary battery state output system capable of outputting the deterioration state of a secondary battery including a content satisfactory to a user in a timely manner.

### Solution to Problem

A state output system of a first invention is a state output system in a system for outputting a deterioration state of a secondary battery mounted on a user device used by a user, including:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, stores the value of the deterioration state in the storage unit in chronological order, and stores use state information, including position information of the user device and indicative of how the secondary battery was used in the past or until now, in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
a detailed deterioration state determination unit which, when the deviation determination unit determines that the most recent deterioration state is deviating from the tendency, acquires, from the use state information, geographical characteristic information as information indicative of geographical characteristics that affect the deterioration state of the secondary battery based on past and/or current position information of the user device to determine, based on the position information and the geographical characteristic information, information on a detailed deterioration state including information on geographical characteristics that affected the deterioration state of the secondary battery and/or information on a response according to the geographical characteristics to be recommended to avoid becoming a deterioration state deviating from the tendency; and
an output unit which outputs the value of the most recent deterioration state recognized by the deterioration state recognition unit and the information on the detailed deterioration state determined by the detailed deterioration state determination unit.

A state output system of a second invention is a state output system in a system for outputting a deterioration state of a secondary battery mounted on a user device used by a user, including:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, and stores the value of the deterioration state in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
an event estimation unit which refers to stored information in which any one of pieces of information indicative of the voltage, current, and the temperature of the secondary battery or a combination thereof is associated with an event occurring in the secondary battery to estimate the event occurring in the secondary battery based on any one of pieces of the information indicative of the voltage, current, and the temperature of the secondary battery or the combination thereof;
a detailed deterioration state determination unit which, when the deviation determination unit determines that the most recent deterioration state is deviating from the tendency, determines information on a detailed deterioration state including information indicative of the event occurring in the secondary battery estimated by the event estimation unit based on any one of pieces of the information indicative of the voltage, current, and the temperature of the secondary battery or the combination thereof; and
an output unit which outputs the value of the most recent deterioration state recognized by the deterioration state recognition unit and the information on the detailed deterioration state determined by the detailed deterioration state determination unit.

A state output system of a third invention is a state output system in a system for outputting a deterioration state of a secondary battery mounted on a user device used by a user, including:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, and stores the value of the deterioration state in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
an event estimation unit which estimates an event occurring in the secondary battery from the value of the most recent deterioration state of the secondary battery and use state information using a predictive model with the value of the deterioration state and the use state information of the secondary battery as input and the event occurring in the secondary battery as output, where the predictive model is obtained by machine learning a correlation between information indicative of values of past deterioration states and use states of the secondary battery and events that occurred in the secondary battery in the past using, as training data, the information indicative of the past deterioration states and use states of the secondary battery mounted on the user device and/or other user devices and information indicative of the events that occurred in the secondary battery in the past;
a detailed deterioration state determination unit which, when the deviation determination unit determines that the most recent deterioration state is deviating from the tendency, determines information on a detailed deterioration state including information indicative of the event occurring in the secondary battery estimated by the event estimation unit based on the value of the most recent deterioration state and the use state information of the secondary battery; and
an output unit which outputs the value of the most recent deterioration state recognized by the deterioration state recognition unit and the information on the detailed deterioration state determined by the detailed deterioration state determination unit.

In the state output system of the present invention, it is determined by the deviation determination unit whether or not the most recent deterioration state is deviating from the tendency based on the tendency of the deterioration state of the secondary battery and the value of the most recent deterioration state of the secondary battery.

Further, when it is determined by the deviation determination unit that the most recent deterioration state is deviating from the tendency, the information on the detailed deterioration state including detailed information is determined by the detailed deterioration state determination unit.

Specifically, it is considered, for example, that temperature varies greatly depending on the region. Further, for example, when the user device is a motor vehicle, the impact of regional characteristics on the deterioration state of the secondary battery, such as that it is a region with many slopes or that there is a need in the region to change the stepping foot frequently between the accelerator pedal and the brake pedal because the road is narrow, is not ignored.

According to the state output system of the first invention, the information on the detailed deterioration state including the information on the geographical characteristics that affected the deterioration state of the secondary battery and/or the information on the response according to the geographical characteristics to be recommended to avoid becoming a deterioration state deviating from the tendency is determined by the detailed deterioration state determination unit.

Thus, since a content of the detailed deterioration state is determined in consideration of the regional characteristics, the user can get information of the deterioration state in line with an actual situation.

Further, in the state output system of the second invention, the stored information in which any one of pieces of information indicative of the voltage, current, and the temperature of the secondary battery or the combination thereof is associated with the event occurring in the secondary battery is referred to and the event occurring in the secondary battery is estimated by the event estimation unit based on any one of pieces of the information indicative of the voltage, current, and the temperature of the secondary battery or the combination thereof, and the information on the detailed deterioration state including the information indicative of the event is determined.

Alternatively, in the state output system of the third invention, the event occurring in the secondary battery is estimated by the event estimation unit from the value of the most recent deterioration state of the secondary battery and the use state information using the predictive model with the value of the deterioration state and the use state information of the secondary battery as input and the event occurring in the secondary battery as output, and the information on the detailed deterioration state including the information indicative of the event is determined.

Thus, since the user can know the event occurring in the secondary battery together, a user's sense of security when using the secondary battery increases.

Then, the value of the most recent deterioration state and the information on the detailed deterioration state are output by the output unit.

Thus, since usual deterioration state information is output while the deterioration state is not deviating from the tendency of the deterioration state, and more detailed information is output when the deterioration state is determined to be deviating from the tendency of the deterioration state, the information to be output to the user can be determined efficiently.

Further, the user can get detailed information when an abnormality in the secondary battery is suspected.

Thus, according to the state output system of the present invention, the deterioration state of the secondary battery including a content satisfactory to the user can be output in a timely manner.

It is preferred that the state output system of the present invention should be such that,
the tendency acquisition unit acquires the tendency of the deterioration state of the secondary battery based on a moving average value of values of deterioration states for a predetermined period among values of past deterioration states of the secondary battery stored in the storage unit, and
when a difference between the moving average value of the values of deterioration states of the secondary battery for the predetermined period and the value of the most recent deterioration state is a predetermined threshold value or more, the deviation determination unit determines that the most recent deterioration state of the secondary battery is deviating from the tendency.

In the state output system of the present invention, the tendency of the deterioration state of the secondary battery is acquired by the tendency acquisition unit based on the moving average value of the values of deterioration states for the predetermined period among the values of the past deterioration states of the secondary battery.

Then, when the difference between the moving average value of the values of the deterioration states of the secondary battery for the predetermined period and the value of the most recent deterioration state is the predetermined threshold value or more, the most recent deterioration state is determined by the deviation determining unit to be deviating from the tendency.

Thus, the user can get reliable information on the deterioration state based on objective information as to whether or not the value of the most recent deterioration state is deviating from the moving average of the values of the deterioration states for the predetermined period.

Thus, according to the state output system of the present invention, the deterioration state of the secondary battery with a content satisfactory to the user and reliable can be output in a timely manner.

Further, it is preferred that the state output system of the present invention should be such that,
the deterioration state recognition unit acquires information indicative of an internal resistance or charging capacity value in an initial state of the secondary battery, and information indicative of a most recent internal resistance or charging capacity value of the secondary battery based on information indicative of most recent voltage, current, and temperature of the secondary battery to recognize a value of an internal resistance increase degree or capacity remaining degree of the secondary battery determined based on the information as a value of the deterioration state of the secondary battery.

In the state output system of the present invention, the information indicative of the internal resistance or charging capacity value in the initial state of the secondary battery, and the information indicative of the most recent internal resistance or charging capacity value of the secondary battery are acquired by the deterioration state recognition unit, and the value of the internal resistance increase degree or capacity remaining degree of the secondary battery determined based on the information is recognized as the value of the deterioration state of the secondary battery.

Thus, the user can get reliable information on the deterioration state based on objective information such as the deterioration state from the viewpoint of the initial state of the secondary battery.

Thus, according to state output system of the present invention, the deterioration state of the secondary battery with a content satisfactory to the user and reliable can be output in a timely manner.

It is preferred that the state output system of the present invention should further include,
a remaining life estimation unit which estimates remaining life as a period until the secondary battery becomes a predetermined deterioration state, wherein
the remaining life estimation unit is configured to predict a future internal resistance or remaining capacity value of the secondary battery from the tendency of the deterioration state of the secondary battery, and to estimate, as the remaining life of the secondary battery, a period until the predicted future internal resistance or charging capacity value of the secondary battery reaches a predefined upper limit of the internal resistance value or lower limit of the charging capacity value of the secondary battery, and
the output unit is configured to output information indicative of the remaining life.

In the state output system of the present invention, the future internal resistance or remaining capacity value of the secondary battery is predicted by the remaining life estimation unit from the tendency of the deterioration state of the secondary battery.

Then, the period until the predicted future internal resistance or charging capacity value of the secondary battery reaches the predefined upper limit of the internal resistance value or lower limit of the charging capacity value of the secondary battery is estimated by the remaining life estimation unit as the remaining life of the secondary battery, and the information indicative of the remaining life is output by the output unit.

Thus, since specific information as to the remaining life of the secondary battery is output, the deterioration degree can be informed to the user in an intuitive manner.

Further, since the remaining life of the secondary battery can be output based on specific information as to an increase in internal resistance or a decrease in charging capacity, user satisfaction with the remaining life increases.

Thus, according to the state output system of the present invention, the deterioration state of the secondary battery with a content satisfactory to the user who can get a sense of satisfaction can be output in a timely manner.

Further, it is preferred that the state output system of the present invention should further include:
a risk level recognition unit which refers to information in which the event occurring in the secondary battery and a risk level of the event are recorded in association with each other to recognize the risk level of the event estimated by the event estimation unit,
wherein the detailed deterioration state determination unit determines the information on the detailed deterioration state based on a content of the event estimated by the event estimation unit and the risk level.

In the state output system of the present invention, the risk level of the event estimated by the event estimation unit is recognized by the risk level recognition unit.

Then, the information on the detailed deterioration state is determined by the detailed deterioration state determination unit based on the content of the estimated event and the risk level.

Thus, since the user can know the event occurring in the secondary battery and whether or not the secondary battery is in a dangerous condition, a sense of security of the user using the secondary battery increases.

Thus, according to the state output system of the present invention, the deterioration state of the secondary battery with a content satisfactory to the user can be output in a timely manner while increasing the sense of security of the user.

Further, it is preferred that the state output system of the present invention should further include
a maintenance engineer device used by a maintenance engineer who performs maintenance of the secondary battery,
wherein when the risk level recognized by the risk level recognition unit meets a predetermined condition, the maintenance engineer device outputs information indicative of the risk level and the content of the event estimated by the event estimation unit.

In the state output system of the present invention, when the risk level recognized by the risk level recognition unit meets the predetermined condition, the information indicative of the risk level and the content of the event estimated by the event estimation unit are output by the maintenance engineer device used by the maintenance engineer who performs the maintenance of the secondary battery.

Thus, since the maintenance engineer can quickly know that the secondary battery is in a dangerous state, and hence can perform necessary maintenance at the right time, the sense of security of the user using the secondary battery increases.

Thus, according to the state output system of the present invention, the deterioration state of the secondary battery with a content satisfactory to the user can be output in a timely manner while increasing the sense of security of the user.

### Brief Description of Drawings

FIG. 1 is a block diagram illustrating an overview of a state output system of the present invention.
FIG. 2A is a chart illustrating a data content used in processing by the state output system of the present invention.
FIG. 2B is a chart illustrating the data content used in processing by the state output system of the present invention.
FIG. 2C is a chart illustrating the data content used in processing by the state output system of the present invention.
FIG. 3A is a flowchart illustrating a processing content of the state output system of the present invention.
FIG. 3B is a flowchart illustrating the processing content of the state output system of the present invention.
FIG. 4 is a chart illustrating the processing content of the state output system of the present invention.
FIG. 5 is a chart illustrating the processing content of the state output system of the present invention.
FIG. 6 is a chart illustrating the processing content of the state output system of the present invention.
FIG. 7 is a chart illustrating the processing content of the state output system of the present invention.
FIG. 8 is a diagram illustrating an output content of the state output system of the present invention.
FIG. 9 is a diagram illustrating the output content of the state output system of the present invention.

### Description of Embodiment

A state output system of an embodiment will be described with reference to the accompanying drawings. Note that the same component is given the same reference numeral so that redundant description may be omitted.

The state output system of the embodiment includes, for example, one or more user devices 10 and a server 30, or further includes a maintenance engineer device 50.

The user device 10 and the server 30, and the maintenance engineer device 50 and the server 30 are communicably connected to each other by a communication network 90.

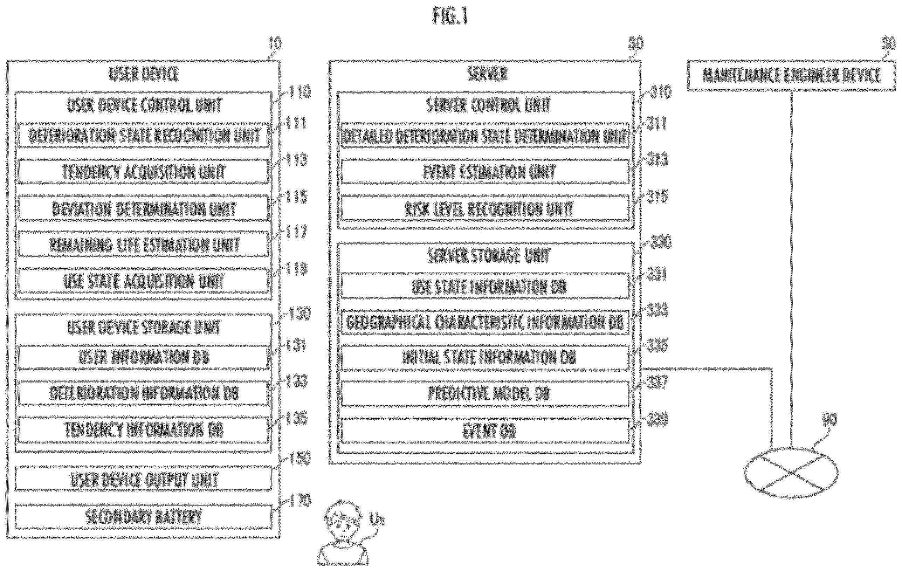

The user device 10 includes a user device control unit 110, a user device storage unit 130, a user device output unit 150, and a secondary battery 170. The user device 10 is, for example, a system using a secondary battery as a whole, such as a motor vehicle like an electric motor vehicle or a hybrid motor vehicle, any other moving body, or a stationary power supply system. Although only one user device 10 is illustrated in FIG. 1, the number of user devices 10 operating at the same time may be plural or may be one.

The user device control unit 110 is composed of an arithmetic processing unit such as a CPU (Central Processing Unit), a memory, an I/O (Input/Output) device, and the like. The user device control unit 110 reads and executes a predetermined program to function, for example, as a deterioration state recognition unit 111, a tendency acquisition unit 113, a deviation determination unit 115, a remaining life estimation unit 117, and a use state acquisition unit 119.

The deterioration state recognition unit 111 recognizes the deterioration state of the secondary battery 170 at any time or in a predetermined cycle. Further, the deterioration state recognition unit 111 transmits, to the server 30, the deterioration state of the secondary battery 170 on a regular basis or at any timing to store the deterioration state in a use state information DB 331.

The tendency acquisition unit 113 acquires a tendency of the deterioration state of the secondary battery 170.

Based on the tendency of the deterioration state of the secondary battery 170 acquired by the tendency acquisition unit 113, and the most recent deterioration state of the secondary battery 170 recognized by the deterioration state recognition unit 111, the deviation determination unit 115 determines whether or not the most recent deterioration state is deviating from the tendency.

The remaining life estimation unit 117 estimates a remaining life as a period until the secondary battery 170 becomes a predetermined deterioration state.

The use state acquisition unit 119 recognizes a use state of the user device 10 at any time or in a predetermined cycle. When the user device 10 is a moving body such as a motor vehicle, for example, the use state includes a condition of stepping on brake pedal/accelerator pedal, what gear it is in, speed, orientation in XYZ directions, location, altitude, whether or not an air conditioner is operating, set temperature, and the like, while when the user device 10 is a stationary power supply system, for example, the user state includes environmental temperature and humidity, weather information, location, vibration, and the like. These pieces of information are acquired by using known sensors and the like. Further, the use state acquisition unit 119 transmits the use state of the secondary battery 170 to the server 30 on a regular basis or at any timing to store the information in the use state information DB 331.

The user device storage unit 130 is composed, for example, of a ROM (Read Only Memory), a RAM (Random Access Memory), and a storage device such as an HDD (Hard Disk Drive). The user device storage unit 130 stores, for example, a user information DB 131 including information for identifying a user Us of the user device 10, a deterioration information DB 133 including information indicative of the deterioration state of the user device 10 recognized by the deterioration state recognition unit 111, and a tendency information DB 135 including information indicative of the tendency of the deterioration state of the secondary battery 170 acquired by the tendency acquisition unit 113.

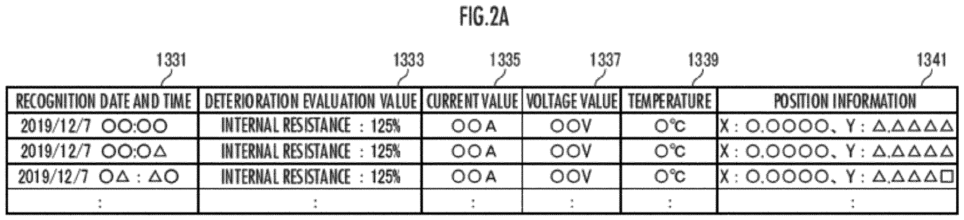

In the deterioration information DB 133, for example, as illustrated in FIG. 2A, items of recognition date and time 1331 as the date and time at which each deterioration state was recognized, deterioration evaluation value 1333 as information indicative of the deterioration state, current value 1335 of the secondary battery 170 as the basis of the deterioration evaluation value, voltage value 1337, temperature 1339, and position information 1341 indicative of a position at which the deterioration state was recognized are stored. The frequency of storing data is, for example, several times a day, once every few minutes, or the like, and a deterioration state recognized at any timing may be stored.

The user device output unit 150 is, for example, a display for outputting the most recent deterioration state of the secondary battery 170 recognized by the deterioration state recognition unit 111, and a detailed deterioration state determined by a detailed deterioration state determination unit 311. The user device output unit 150 functions as an output unit in the embodiment.

The secondary battery 170 is, for example, a lithium ion battery, but it may also be any other battery capable of being used iteratively as a power supply by repeating charging and discharging, such as a nickel-cadmium battery, a lead battery, or a fuel cell.

The server 30 is, for example, a computer including a server control unit 310 and a server storage unit 330.

The server control unit 310 is composed of an arithmetic processing unit such as a CPU, a memory, an I/O device, and the like. The server control unit 310 reads and executes a predetermined program to function, for example, as the detailed deterioration state determination unit 311, or in addition thereto, further as an event estimation unit 313 and a risk level recognition unit 315.

When the deviation determination unit 115 determines that the most recent deterioration state of the secondary battery 170 is deviating from the tendency, the detailed deterioration state determination unit 311 acquires, from the server storage unit 330, use state information as information indicating how the secondary battery was used by the most recent time point, and based on the most recent deterioration state and the use state information, determines a detailed deterioration state including information indicative of a deterioration state of the secondary battery 170 more detailed than the most recent deterioration state.

Based on the most recent deterioration state and the use state information of the secondary battery 170, the event estimation unit 313 estimates an event occurring in the secondary battery 170.

The risk level recognition unit 315 recognizes a risk level of the event occurring in the secondary battery 170 estimated by the event estimation unit 313.

The server storage unit 330 is composed, for example, of a ROM, a RAM, and a storage device such as an HDD. The server storage unit 330 stores the use state information DB 331 including use state information as information indicating how the secondary battery 170 was used by the most recent time point, or in addition thereto, further stores a geographical characteristic information DB 333 including geographical characteristic information as information indicative of geographical characteristics that affect the deterioration state of the secondary battery 170, an initial state information DB 335 including information indicative of an internal resistance or charging capacity value in the initial state of the secondary battery 170, a predictive model DB 337 in which a predictive model used by the event estimation unit 313 to estimate an event, and an event DB 339 in which information related to each event that can occur in the secondary battery is stored.

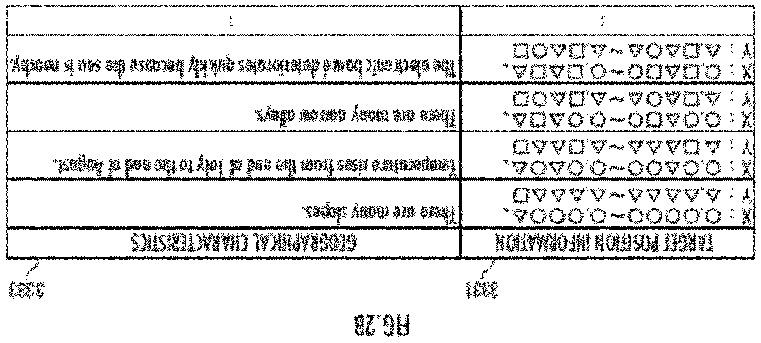

In the geographical characteristic information DB 333, for example, as illustrated in FIG. 2B, target position information 3331 indicative of a range of position information as a target of the geographical characteristics, and geographical characteristics 3333 in the range are stored.

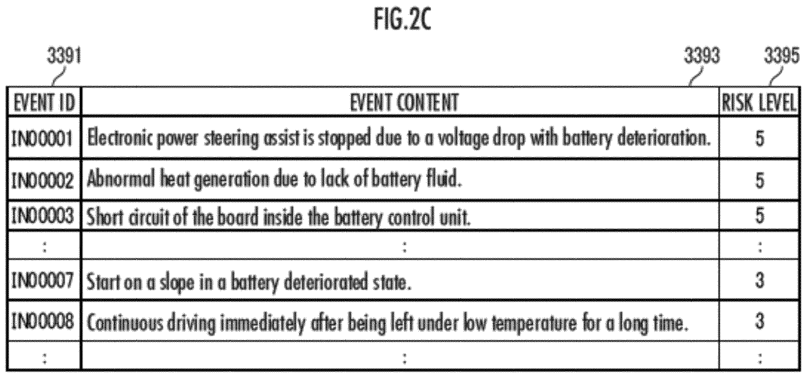

In the event DB 339, for example, as illustrated in FIG. 2C, an event ID 3391 for identifying each event, an event content 3393 indicative of the content of the event, and a risk level 3395 of the event are stored.

The maintenance engineer device 50 is a device, such as a computer, a tablet terminal, or a smartphone, used by a maintenance engineer who performs the maintenance of the secondary battery.

When a risk level recognized by the risk level recognition unit 315 meets a predetermined condition, the maintenance engineer device 50 outputs information indicative of the risk level and the content of an event estimated by the event estimation unit 313.

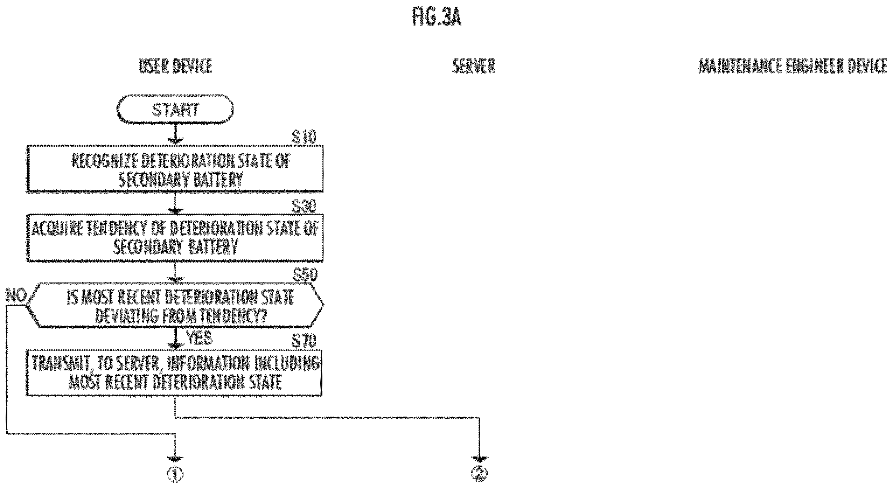

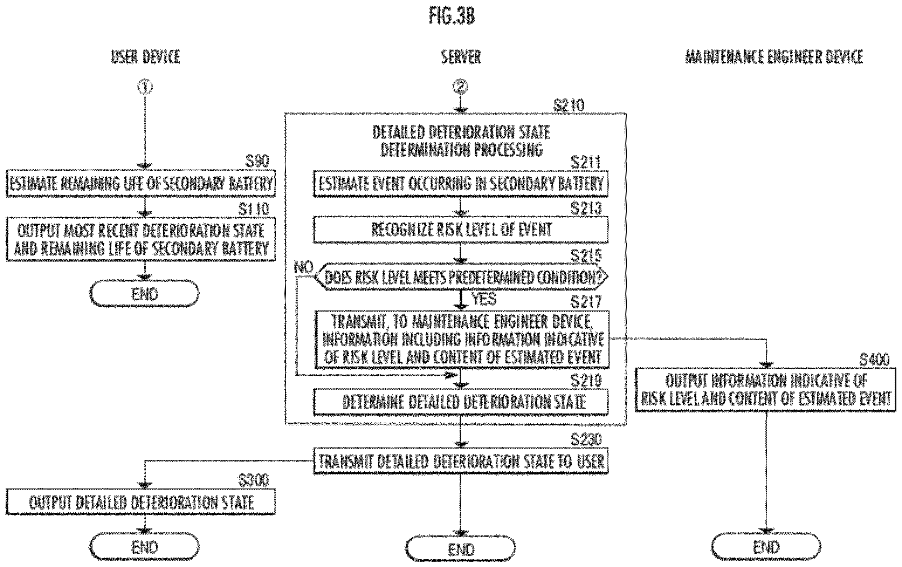

Referring next to FIG. 3A and FIG. 3B, a processing content of the state output system of the embodiment will be described.

### <Outline of Processing>

A series of processing by the state output system of the embodiment is executed repeatedly at a predetermined frequency. When the processing is started, the deterioration state recognition unit 111 of the user device 10 first recognizes the deterioration state of the secondary battery 170 (FIG. 3A/S10). The deterioration state recognition unit 111 stores the recognized deterioration state in the deterioration information DB 133 in chronological order.

For example, the deterioration state recognition unit 111 acquires, from the secondary battery 170, information indicative of the voltage, current, and temperature of the secondary battery 170 to recognize the deterioration state of the secondary battery 170 based on the acquired information.

More specifically, for example, the deterioration state recognition unit 111 acquires, from the user device storage unit 130, information indicative of an internal resistance or charging capacity value in the initial state of the secondary battery 170, and performs a predetermined operation based on the information indicative of the voltage, current, and temperature of the secondary battery 170 acquired from the secondary battery 170 to acquire information indicative of a most recent internal resistance or charging capacity value of the secondary battery 170. Then, for example, the deterioration state recognition unit 111 calculates a ratio between the internal resistance or charging capacity in the initial state of the secondary battery 170 and the most recent internal resistance or charging capacity to determine the internal resistance increase rate or capacity remaining rate of the secondary battery 170 in order to recognize the deterioration state of the secondary battery 170 based on the determined internal resistance increase rate or capacity remaining rate.

Then, the tendency acquisition unit 113 acquires a tendency of the deterioration state of the secondary battery 170 (FIG. 3A/S30). The tendency acquisition unit 113 acquires the tendency of the deterioration state of the secondary battery 170 based, for example, on a moving average value of deterioration states of the secondary battery 170 for a predetermined period, where each deterioration state of the secondary battery 170 is calculated by using a deterioration evaluation value obtained by quantifying the deterioration state of the secondary battery 170. The tendency acquisition unit 113 stores the acquired tendency of the deterioration state in the tendency information DB 135 in chronological order.

More specifically, for example, the tendency acquisition unit 113 calculates the moving average value of deterioration states of the secondary battery 170 for the predetermined period by using, as the deterioration evaluation value, the internal resistance increase degree or the capacity remaining degree of the secondary battery 170 determined by the deterioration state recognition unit 111 in S10. The predetermined period is, for example, one month, half a year, or the like, but it may be any period shorter or longer than the predetermined period, or the period may be changed at any time according to the values of the information indicative of the voltage, current, and temperature of the secondary battery 170 and the deterioration evaluation value.

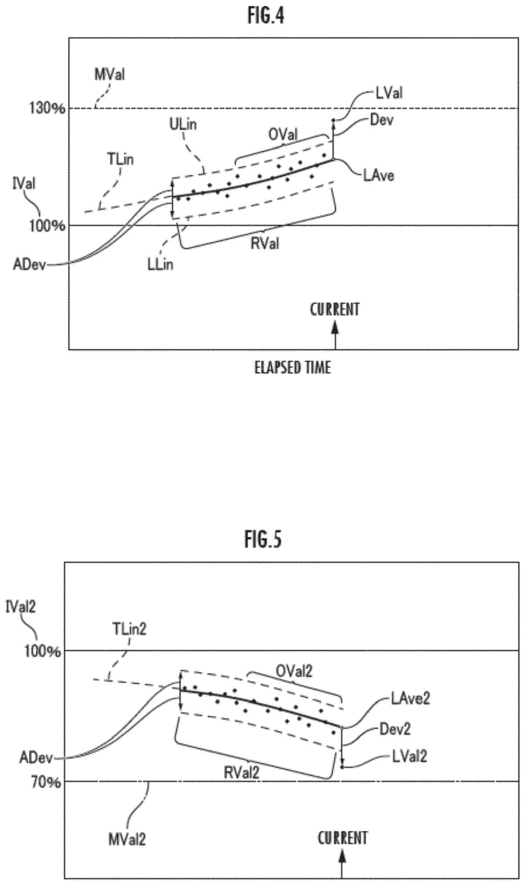

FIG. 4 illustrates an example when the tendency of the deterioration state of the secondary battery 170 is acquired based on a moving average value of internal resistance increase degrees. In FIG. 4, N deterioration states OVal as deterioration states during the predetermined period are extracted from past M deterioration states RVal recorded in the deterioration information DB 133, and a moving average value of the extracted N deterioration states OVal becomes a latest moving average value LAve of the N deterioration states.

Further, a line TLin of connecting moving average values at respective past time points calculated in the same way represents a tendency of the deterioration state of the secondary battery 170. Note that a value indicating the deterioration state at each time point is a value of the internal resistance at each time point when a value IVal of the internal resistance in the initial state of the secondary battery 170 is set to 100% (that is to say, 130% if the value of the internal resistance has increased by 30%).

FIG. 5 illustrates an example when the tendency of the deterioration state of the secondary battery 170 is acquired based on a moving average value of capacity remaining degrees. In FIG. 5, N deterioration states OVal2 as deterioration states during the predetermined period are extracted from past M deterioration states RVal2 recorded in the deterioration information DB 133, and a moving average value of the extracted N deterioration states OVal2 becomes a latest moving average value LAve2 of the N deterioration states.

Further, a line TLin2 of connecting moving average values at respective past time points calculated in the same way represents a tendency of the deterioration state of the secondary battery 170. Note that a value indicating the deterioration state at each time point is a value of the remaining capacity at each time point when a value IVal2 of the charging capacity in the initial state of the secondary battery 170 is set to 100% (that is to say, 70% if the value of the charging capacity has decreased by 30%).

Next, the deviation determination unit 115 determines whether or not a most recent deterioration state is deviating from the tendency of the deterioration state of the secondary battery 170 (FIG. 3A/S50).

For example, the deviation determination unit 115 determines that the most recent deterioration state is deviating from the tendency when a difference Dev between a most recent moving average value LAve of deterioration states of the secondary battery 170 and the most recent deterioration evaluation value LVal is a predetermined threshold value or more. For example, in FIG. 4, a dashed line ULin above the latest moving average value LAve of deterioration states of the secondary battery 170 represents an upper threshold value of the difference Dev and a dashed line LLin below thereof represents a lower threshold value, respectively.

In other words, the distance from the line TLin of connecting the moving average values to the dashed line ULin above and the distance therefrom to the dashed line LLin below become allowable deviations ADev in up and down directions, respectively.

In FIG. 4, since the most recent deterioration evaluation value LVal is a value exceeding the upper dashed line ULin, the deviation determination unit 115 determines that the most recent deterioration state is deviating from the tendency of the deterioration state of the secondary battery 170. On the other hand, the deviation determination unit 115 determines that the most recent deterioration state is not deviating from the tendency of the deterioration state of the secondary battery 170 when the most recent deterioration evaluation value LVal is a value on the upper dashed line ULin or less and on the lower dashed line LLin or more.

When the determination is negative (FIG. 3A/S50: No), the deterioration state of the secondary battery 170 is not deviating from the tendency. In this case, for example, the remaining life estimation unit 117 estimates the remaining life as a period until the secondary battery 170 becomes a predetermined deterioration state (FIG. 3B/S90).

More specifically, the remaining life estimation unit 117 acquires a tendency of the deterioration state of the secondary battery 170 from the tendency information DB 135 to predict a value of future internal resistance or remaining capacity of the secondary battery 170 from the acquired tendency of the deterioration state of the secondary battery 170. Then, the remaining life estimation unit 117 calculates a period until the predicted future internal resistance or charging capacity value of the secondary battery 170 reaches a predefined upper limit of the internal resistance value or lower limit of the charging capacity value of the secondary battery 170 to estimate the calculated period as the remaining life of the secondary battery.

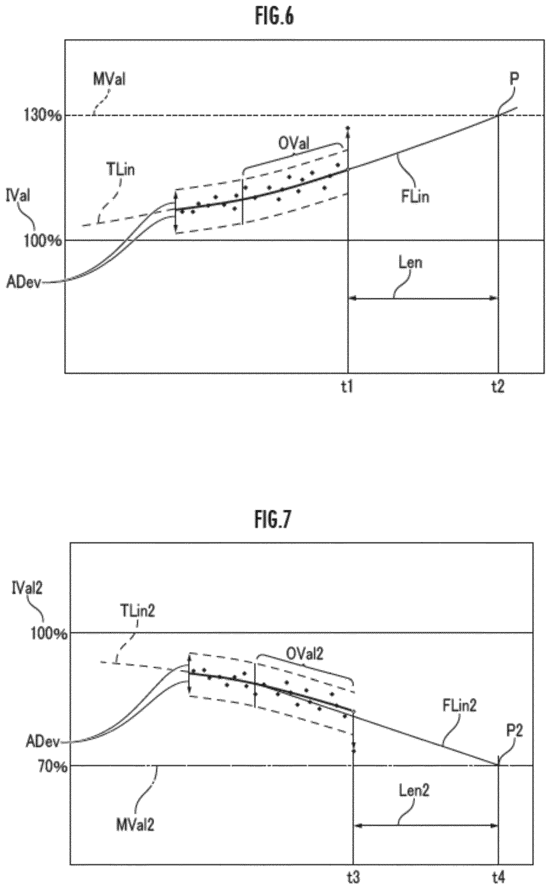

FIG. 6 illustrates an example when the remaining life estimation unit 117 predicts a value of future internal resistance of the secondary battery 170 from the tendency of the internal resistance increase degree of the secondary battery 170. In FIG. 6, for example, the remaining life estimation unit 117 determines an approximate curve of the line TLin that represents the tendency of the deterioration state of the secondary battery 170 to derive a line FLin that represents the future internal resistance of the secondary battery 170.

Then, the remaining life estimation unit 117 determines time point t2 corresponding to an intersection P between the dashed line MVal indicative of the predefined upper limit of the internal resistance value (in the present example, the value of the internal resistance is 130%), and the line FLin to estimate that a length Len of a period between the time point t2 and time point t1, at which the most recent deterioration evaluation value LVal was acquired, is the remaining life of the secondary battery 170.

FIG. 7 illustrates an example when the remaining life estimation unit 117 predicts a value of future internal resistance of the secondary battery 170 from the tendency of the internal resistance increase degree of the secondary battery 170. In FIG. 7, for example, the remaining life estimation unit 117 determines an approximate curve of the line TLin2 that represents the tendency of the deterioration state of the secondary battery 170 to derive a line FLin2 that represents a change in future charging capacity of the secondary battery 170.

Then, the remaining life estimation unit 117 determines time point t4 corresponding to an intersection P2 between a dot-dashed line MVal2 indicative of a predefined lower limit of the charging capacity value (in the present example, the charging capacity value is 70%), and the line FLin2 to estimate that a length Len2 of a period between the time point t4 and time point t3, at which a most recent deterioration evaluation value LVal2 was acquired, is the remaining life of the secondary battery 170.

Then, the user device output unit 150 outputs the most recent deterioration state of the secondary battery 170 recognized by the deterioration state recognition unit 111 and the remaining life estimated by the remaining life estimation unit 117 (FIG. 3B/S110), and the series of processing is ended.

On the other hand, when the above determination is affirmative (FIG. 3A/S50: Yes), since the deterioration state of the secondary battery 170 is deviating from the tendency, the deviation determination unit 115 transmits, to the server 30, information including the most recent deterioration state (FIG. 3A/S70). On this occasion, the deviation determination unit 115 acquires information to identify the user device 10 from the user information DB 131 and transmits, to the server 30, the information together with the most recent deterioration state.

Then, the server 30 that received the information executes detailed deterioration state determination processing (FIG. 3B/S210) as a series of processing to determine a detailed deterioration state including information indicative of a more detailed deterioration state of the secondary battery than the most recent deterioration state. The content of the processing will be described later.

After that, the detailed deterioration state determination unit 311 transmits the detailed deterioration state to the user device 10, and the processing is ended.

Then, the user device output unit 150 of the user device 10 that received the detailed deterioration state outputs the received detailed deterioration state (FIG. 3B/S300), and the series of processing by the state output system of the present embodiment is ended.

### <Detailed Deterioration State Determination Processing>

When the processing is started, the event estimation unit 313 estimates an event occurring in the secondary battery 170 based on the most recent deterioration state and use state information of the secondary battery 170 (FIG. 3B/S211).

More specifically, the event estimation unit 313 acquires, from the predictive model DB 337, a predictive model machine-learned by using, as training data, information indicative of past deterioration states and use states of the secondary battery 170 mounted on the user device 10 and/or the other user devices 10, and information indicative of events that occurred in the secondary battery 170 in the past, and uses the predictive model to estimate an event occurring in the secondary battery 170 from the most recent deterioration state of the secondary battery 170 and the use state information.

After that, the risk level recognition unit 315 recognizes a risk level of the event occurring in the secondary battery 170 estimated by the event estimation unit 313 (FIG. 3B/S213).

For example, the risk level recognition unit 315 refers to the event DB to recognize the risk level corresponding to the event occurring in the secondary battery 170. Then, the risk level recognition unit 315 determines whether or not the recognized risk level meets a predetermined condition (FIG. 3B/S215). The predetermined condition is, for example, whether or not the event is a specific event, or when the risk level is indicated by a numeric value as illustrated in FIG. 2B, the predetermined condition may be whether or not the risk level is a predetermined numeric value or more.

When the determination is affirmative (FIG. 3B/S215: Yes), the risk level recognition unit 315 transmits, to the maintenance engineer device 50, information including information indicative of the risk level, the content of the estimated event, and information to identify the user Us (FIG. 3B/S217).

The maintenance engineer device 50 that received the information including the information indicative of the risk level and the content of the estimated event outputs the information indicative of the risk level and the content of the estimated event together with the information to identify the user Us (such as telephone number, address, and the like) (FIG. 3B/S400).

The maintenance engineer device 50 may be configured to further output details of copying with the event according to the content of the estimated event, such as information to encourage the maintenance to replace the battery immediately or the like.

After that, or when the determination is negative (FIG. 3B/S215: No), the risk level recognition unit 315 determines the detailed deterioration state.

More specifically, the detailed deterioration state determination unit 311 determines the detailed deterioration state based on the content of the event estimated by the event estimation unit 313 and the risk level recognized by the risk level recognition unit 315.

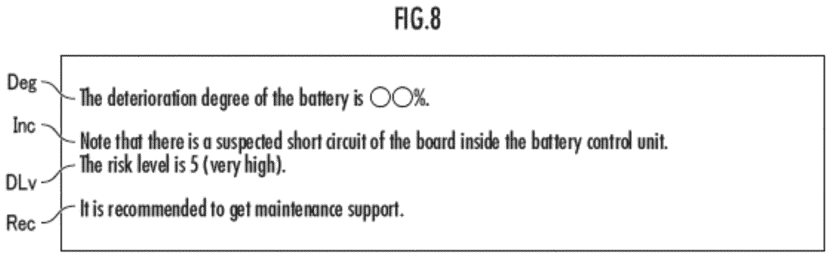

FIG. 8 illustrates a state in which the detailed deterioration state thus determined is output by the user device output unit 150.

In an example illustrated in FIG. 8, the deviation determination unit 115 determines that the deterioration state is deviating from the tendency because the degree of deterioration has increased by a predetermined value or more.

Then, based on the most recent deterioration state and the use state information of the secondary battery 170, the event estimation unit 313 estimates that "there is a suspected short circuit of the board inside the battery control unit," and the risk level recognition unit 315 recognizes that the risk level of the event is 5.

In response to this, the detailed deterioration state determination unit 311 determines information on the content of the estimated event, the recognized risk level, and a recommended response.

Through such processing, an indication Rec indicative of the recommended response is output together with an indication Deg indicative of the deterioration state of the secondary battery 170, a content Inc of the estimated event, and a risk level DLv as illustrated in FIG. 8.

Alternatively, the detailed deterioration state determination unit 311 acquires past and/or current position information of the user device 10 from the use state information DB 331 to acquire, from the server storage unit 330, geographical characteristic information as information indicative of geographical characteristics that affect the deterioration state of the secondary battery 170 based on the acquired information in order to determine the detailed deterioration state based on the position information and the geographical characteristic information.

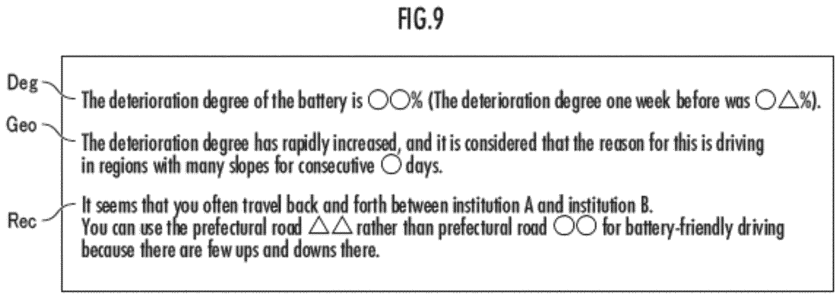

FIG. 9 illustrates a state in which the detailed deterioration state thus determined is output by the user device output unit 150.

In an example illustrated in FIG. 9, the deviation determination unit 115 determines that the deterioration state of the secondary battery 170 is deviating from the tendency due to a rapid increase in deterioration degree.

Then, based on the most recent deterioration state and the use state information of the secondary battery 170, the event estimation unit 313 first recognizes that the deterioration degree increased rapidly compared with the deterioration degree one week ago and, in response thereto, compares a usage situation in the last week and a usage situation before then to determine whether or not there is some change.

In the present example, since the event estimation unit 313 recognizes from the position information that driving in a certain geographical range in the last several days has been increasing, the event estimation unit 313 further refers to the geographical characteristic information DB 333 to recognize such a geographical characteristic that "there are many slopes" in the range, or the event estimation unit 313 further refers to the use state information DB 331 to analyze information indicative of past deterioration states and use states of secondary batteries 170 mounted on user devices 10 other than the user device 10 concerned so as to calculate a likelihood that this event occurring in the secondary battery 170 is "worsening of the deterioration state due to driving in regions with many slopes for several consecutive days," and when the likelihood is a predetermined value or more, the event estimation unit 313 estimates that this event is "worsening of the deterioration state due to driving in regions with many slopes for several consecutive days."

Then, after considering the geographical characteristic information, the detailed deterioration state determination unit 311 determines the content of the estimated event and a recommended response.

In the present example, for example, since the detailed deterioration state determination unit 311 further analyzes information indicative of past deterioration states and use states of secondary batteries 170 mounted on user devices 10 other than the user device 10 concerned to recognize that the rapid increase in deterioration degree can be suppressed by avoiding driving on slopes, the detailed deterioration state determination unit 311 determines the detailed deterioration state including information to recommend the user to go the other way.

Through such processing, an indication Deg indicative of the deterioration state of the secondary battery 170, a content Geo of the event estimated after considering the geographical characteristic information, and an indication Rec indicative of the recommended response are output as illustrated in FIG. 9.

Thus, the most recent or past deterioration state and the detailed deterioration state may be displayed on the user device output unit 150 at the same time, or either one of them may be displayed by switching the display or the like.

As described above, according to the state output system of the present invention, there can be provided a secondary battery state output system capable of outputting the deterioration state of the secondary battery including a content satisfactory to the user in a timely manner.

While the embodiment of the present invention has been described above, the present invention is not limited to this embodiment. Various changes are possible without departing from the scope of the present invention.

For example, instead of or in addition to the display, the user device output unit 150 may be a speaker to output the deterioration state and the detailed deterioration state by voice.

For example, the user device 10 may be composed of two or more devices. In other words, for example, the user device 10 may be composed of a combination of a motor vehicle, on which the secondary battery 170 is mounted, and a general-purpose device such as a smartphone or a dedicated device communicably connected to the motor vehicle.

For example, although sharing of the processing content between the user device 10 and the server 30 is specifically described above, the present invention is not limited thereto. In other words, for example, part of processing may be executed on the server 30 rather than the user device 10, or on the user device 10 rather than the server 30. Alternatively, for example, the server 30 may be so omitted that all processing is executed on the user device 10.

For example, the event estimation unit 313 may refer to a table prestored in the server storage unit 330 and in which any of the current, the voltage, and the temperature of the secondary battery 170 or a combination thereof, any other parameter, and an event estimated to be occurring in the secondary battery 170 are associated with one another to estimate the event occurring in the secondary battery 170 based on these parameters.

### Description of Reference Numerals

10...user device, 111...deterioration state recognition unit, 113...tendency acquisition unit, 115... deviation determination unit, 117...remaining life estimation unit, 150... user device output unit, 170... secondary battery, 311... detailed deterioration state determination unit, 313 ... event estimation unit, 315 ... risk level recognition unit, 50... maintenance engineer device.

## Claims

1. A state output system in a system for outputting a deterioration state of a secondary battery mounted on a user device used by a user, comprising:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, stores the value of the deterioration state in the storage unit in chronological order, and stores use state information, including position information of the user device and indicative of how the secondary battery was used in the past or until now, in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
a detailed deterioration state determination unit which, in a case where the deviation determination unit determines that the most recent deterioration state is deviating from the tendency, acquires, from the use state information, geographical characteristic information as information indicative of geographical characteristics that affect the deterioration state of the secondary battery based on past and/or current position information of the user device to determine, based on the position information and the geographical characteristic information, information on a detailed deterioration state including information on geographical characteristics that affected the deterioration state of the secondary battery and/or information on a response according to the geographical characteristics to be recommended to avoid becoming a deterioration state deviating from the tendency; and
an output unit which outputs the value of the most recent deterioration state recognized by the deterioration state recognition unit and the information on the detailed deterioration state determined by the detailed deterioration state determination unit.

2. A state output system in a system for outputting a deterioration state of a secondary battery mounted on a user device used by a user, comprising:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, and stores the value of the deterioration state in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
an event estimation unit which refers to stored information in which any one of pieces of information indicative of the voltage, current, and the temperature of the secondary battery or a combination thereof is associated with an event occurring in the secondary battery to estimate the event occurring in the secondary battery based on any one of pieces of the information indicative of the voltage, current, and the temperature of the secondary battery or the combination thereof;
a detailed deterioration state determination unit which, in a case where the deviation determination unit determines that the most recent deterioration state is deviating from the tendency, determines information on a detailed deterioration state including information indicative of the event occurring in the secondary battery estimated by the event estimation unit based on any one of pieces of the information indicative of the voltage, current, and the temperature of the secondary battery or the combination thereof; and
an output unit which outputs the value of the most recent deterioration state recognized by the deterioration state recognition unit and the information on the detailed deterioration state determined by the detailed deterioration state determination unit.

3. A state output system in a system for outputting a deterioration state of a secondary battery mounted on a user device used by a user, comprising:
a storage unit which stores information;
a deterioration state recognition unit which quantifies a deterioration state of the secondary battery based on information indicative of voltage, current, and temperature of the secondary battery, recognizes the quantified value as a value of the deterioration state of the secondary battery, and stores the value of the deterioration state in the storage unit in chronological order;
a tendency acquisition unit which acquires a tendency of the deterioration state of the secondary battery based on values of deterioration states of the secondary battery at a plurality of past time points stored in the storage unit;
a deviation determination unit which determines whether or not a most recent deterioration state is deviating from the tendency based on the tendency of the deterioration state of the secondary battery acquired by the tendency acquisition unit and a value of the most recent deterioration state of the secondary battery recognized by the deterioration state recognition unit;
an event estimation unit which estimates an event occurring in the secondary battery from the value of the most recent deterioration state of the secondary battery and use state information using a predictive model with the value of the deterioration state and the use state information of the secondary battery as input and the event occurring in the secondary battery as output, where the predictive model is obtained by machine learning a correlation between information indicative of values of past deterioration states and use states of the secondary battery and events that occurred in the secondary battery in the past using, as training data, the information indicative of the past deterioration states and use states of the secondary battery mounted on the user device and/or other user devices and information indicative of the events that occurred in the secondary battery in the past;
a detailed deterioration state determination unit which, in the case where the deviation determination unit determines that the most recent deterioration state is deviating from the tendency, determines information on a detailed deterioration state including information indicative of the event occurring in the secondary battery estimated by the event estimation unit based on the value of the most recent deterioration state and the use state information of the secondary battery; and
an output unit which outputs the value of the most recent deterioration state recognized by the deterioration state recognition unit and the information on the detailed deterioration state determined by the detailed deterioration state determination unit.

4. The state output system according to any one of claims 1 to 3, wherein
the tendency acquisition unit acquires the tendency of the deterioration state of the secondary battery based on a moving average value of values of deterioration states of the secondary battery for a predetermined period among values of the past deterioration states of the secondary battery stored in the storage unit, and
in a case where a difference between the moving average value of the values of deterioration states of the secondary battery for the predetermined period and the value of the most recent deterioration state is a predetermined threshold value or more, the deviation determination unit determines that the most recent deterioration state is deviating from the tendency.

5. The state output system according to any one of claims 1 to 4, wherein the deterioration state recognition unit acquires information indicative of an internal resistance or charging capacity value in an initial state of the secondary battery, and information indicative of a most recent internal resistance or charging capacity value of the secondary battery based on information indicative of most recent voltage, current, and temperature of the secondary battery to recognize a value of an internal resistance increase degree or capacity remaining degree of the secondary battery determined based on the information as a value of the deterioration state of the secondary battery.

6. The state output system according to any one of claims 1 to 5, further comprising
a remaining life estimation unit which estimates remaining life as a period until the secondary battery becomes a predetermined deterioration state, wherein
the remaining life estimation unit is configured to predict a future internal resistance or remaining capacity value of the secondary battery from the tendency of the deterioration state of the secondary battery, and to estimate, as the remaining life of the secondary battery, a period until the predicted future internal resistance or charging capacity value of the secondary battery reaches a predefined upper limit of the internal resistance value or lower limit of the charging capacity value of the secondary battery, and
the output unit is configured to output information indicative of the remaining life.

7. The state output system according to claim 2 or 3, further comprising
a risk level recognition unit which refers to information in which the event occurring in the secondary battery and a risk level of the event are recorded in association with each other to recognize the risk level of the event estimated by the event estimation unit,
wherein the detailed deterioration state determination unit determines the information on the detailed deterioration state based on a content of the event estimated by the event estimation unit and the risk level.

8. The state output system according to claim 7, further comprising
a maintenance engineer device used by a maintenance engineer who performs maintenance of the secondary battery,
wherein when the risk level recognized by the risk level recognition unit meets a predetermined condition, the maintenance engineer device outputs information indicative of the risk level and the content of the event estimated by the event estimation unit.

## Patentansprüche

1. Zustandsausgabesystem in einem System zum Ausgeben eines Verschlechterungszustands einer Sekundärbatterie, die an einer von einem Benutzer verwendeten Benutzervorrichtung angebracht ist, umfassend:
eine Speichereinheit, die Informationen speichert;
eine Einheit zur Erkennung eines Verschlechterungszustands, die einen Verschlechterungszustand der Sekundärbatterie auf Basis von Informationen, die Spannung, Strom und Temperatur der Sekundärbatterie angeben, quantifiziert, den quantifizierten Wert als einen Wert des Verschlechterungszustands der Sekundärbatterie erkennt, den Wert des Verschlechterungszustands in der Speichereinheit in chronologischer Reihenfolge speichert, und Informationen zum Verwendungsstatus, die Informationen zur Position der Benutzervorrichtung umfassen und angeben, wie die Sekundärbatterie in der Vergangenheit oder bis jetzt verwendet wurde, in der Speichereinheit in chronologischer Reihenfolge speichert;
eine Tendenzerfassungseinheit, die eine Tendenz des Verschlechterungszustands der Sekundärbatterie auf Basis von Werten von Verschlechterungszuständen der Sekundärbatterie an mehreren vergangenen Zeitpunkten, die in der Speichereinheit gespeichert sind, erfasst;
eine Einheit zur Bestimmung einer Abweichung, die, basierend auf der Tendenz des Verschlechterungszustands der Sekundärbatterie, die von der Tendenzerfassungseinheit erfasst wurde, und einem Wert des jüngsten Verschlechterungszustands der Sekundärbatterie, der von der Einheit zur Erkennung eines Verschlechterungszustands erkannt wurde, bestimmt, ob ein jüngster Verschlechterungszustand von der Tendenz abweicht oder nicht abweicht;
eine Einheit zur Bestimmung eines detaillierten Verschlechterungszustands, die in einem Fall, in dem die Einheit zur Bestimmung einer Abweichung bestimmt, dass der jüngste Verschlechterungszustand von der Tendenz abweicht, aus den Informationen zum Verwendungsstatus Informationen zu geographischen Charakteristika als Informationen, die auf geographische Charakteristika hinweisen, welche den Verschlechterungszustand der Sekundärbatterie beeinflussen, basierend auf Informationen zu vergangenen und/oder aktuellen Positionen der Benutzervorrichtung erfasst, um auf Basis der Positionsinformationen und der Informationen zu geographischen Charakteristika Informationen bezüglich eines detaillierten Verschlechterungszustands einschließlich Informationen bezüglich geographischer Charakteristika, die den Verschlechterungszustand der Sekundärbatterie beeinflusst haben, und/oder Informationen bezüglich einer Reaktion, die entsprechend den geographischen Charakteristika zu empfehlen ist, zu bestimmen, um zu vermeiden, dass ein Verschlechterungszustand eintritt, der von der Tendenz abweicht; und
eine Ausgabeeinheit, die den Wert des jüngsten Verschlechterungszustands, der von der Einheit zur Erkennung eines Verschlechterungszustands erkannt wurde, und die Informationen bezüglich des detaillierten Verschlechterungszustands, die von der Einheit zur Bestimmung eines detaillierten Verschlechterungszustands bestimmt wurden, ausgibt.

2. Zustandsausgabesystem in einem System zum Ausgeben eines Verschlechterungszustands einer Sekundärbatterie, die an einer von einem Benutzer verwendeten Benutzervorrichtung angebracht ist, umfassend:
eine Speichereinheit, die Informationen speichert;
eine Einheit zur Erkennung eines Verschlechterungszustands, die einen Verschlechterungszustand der Sekundärbatterie auf Basis von Informationen, die Spannung, Strom und Temperatur der Sekundärbatterie angeben, quantifiziert, den quantifizierten Wert als einen Wert des Verschlechterungszustands der Sekundärbatterie erkennt, und den Wert des Verschlechterungszustands in der Speichereinheit in chronologischer Reihenfolge speichert,
eine Tendenzerfassungseinheit, die eine Tendenz des Verschlechterungszustands der Sekundärbatterie basierend auf den Werten von Verschlechterungszuständen der Sekundärbatterie an mehreren vergangenen Zeitpunkten, die in der Speichereinheit gespeichert sind, erfasst;
eine Einheit zur Bestimmung einer Abweichung, die, basierend auf der Tendenz des Verschlechterungszustands der Sekundärbatterie, die von der Tendenzerfassungseinheit erfasst wurde, und einem Wert des jüngsten Verschlechterungszustands der Sekundärbatterie, der von der Einheit zur Erkennung eines Verschlechterungszustands erkannt wurde, bestimmt, ob ein jüngster Verschlechterungszustand von der Tendenz abweicht oder nicht abweicht;
eine Ereigniseinschätzungseinheit, die sich auf gespeicherte Informationen bezieht, in denen ein beliebiges der Teile der Informationen, die die Spannung, den Strom und die Temperatur der Sekundärbatterie oder eine Kombination hiervon angeben, mit einem in der Sekundärbatterie auftretenden Ereignis verbunden ist, um das in der Sekundärbatterie auftretende Ereignis auf Basis eines beliebigen der Teile der Informationen, die die Spannung, den Strom und die Temperatur der Sekundärbatterie oder die Kombination hiervon angeben, einzuschätzen;
eine Einheit zur Bestimmung eines detaillierten Verschlechterungszustands, die - in einem Fall, in dem die Einheit zur Bestimmung einer Abweichung bestimmt, dass der jüngste Verschlechterungszustand von der Tendenz abweicht - Informationen bezüglich eines detaillierten Verschlechterungszustands, einschließlich Informationen, die auf das in der Sekundärbatterie auftretende Ereignis hinweisen, das von der Ereigniseinschätzungseinheit auf Basis eines beliebigen der Teile der die Spannung, den Strom und die Temperatur der Sekundärbatterie oder die Kombination hiervon angebenden Informationen eingeschätzt wurde, bestimmt;
eine Ausgabeeinheit, die den Wert des jüngsten Verschlechterungszustands, der von der Einheit zur Erkennung eines Verschlechterungszustands erkannt wurde, und die Informationen über den detaillierten Verschlechterungszustand, die von der Einheit zur Bestimmung eines detaillierten Verschlechterungszustands bestimmt wurden, ausgibt.

3. Zustandsausgabesystem in einem System zum Ausgeben eines Verschlechterungszustands einer Sekundärbatterie, die an einer von einem Benutzer verwendeten Benutzervorrichtung angebracht ist, umfassend:
eine Speichereinheit, die Informationen speichert;
eine Einheit zur Erkennung eines Verschlechterungszustands, die einen Verschlechterungszustand der Sekundärbatterie auf Basis von Informationen, die Spannung, Strom und Temperatur der Sekundärbatterie angeben, quantifiziert, den quantifizierten Wert als einen Wert des Verschlechterungszustands der Sekundärbatterie erkennt, und den Wert des Verschlechterungszustands in der Speichereinheit in chronologischer Reihenfolge speichert,
eine Tendenzerfassungseinheit, die eine Tendenz des Verschlechterungszustands der Sekundärbatterie auf Basis von Werten von Verschlechterungszuständen der Sekundärbatterie an mehreren vergangenen Zeitpunkten, die in der Speichereinheit gespeichert sind, erfasst;
eine Einheit zur Bestimmung einer Abweichung, die, basierend auf der Tendenz des Verschlechterungszustands der Sekundärbatterie, die von der Tendenzerfassungseinheit erfasst wurde, und einem Wert des jüngsten Verschlechterungszustands der Sekundärbatterie, der von der Einheit zur Erkennung eines Verschlechterungszustands erkannt wurde, bestimmt, ob ein jüngster Verschlechterungszustand von der Tendenz abweicht oder nicht abweicht;
eine Ereigniseinschätzungseinheit, die ein in der Sekundärbatterie auftretendes Ereignis aus dem Wert des jüngsten Verschlechterungszustands der Sekundärbatterie und aus den Informationen zum Verwendungsstatus unter Verwendung eines Vorhersagemodells mit dem Wert des Verschlechterungszustands und den Informationen zum Verwendungsstatus der Sekundärbatterie als Eingabe und dem in der Sekundärbatterie auftretenden Ereignis als Ausgabe einschätzt, wobei das Vorhersagemodell durch maschinelles Lernen einer Korrelation zwischen Informationen, die Werte von vergangenen Verschlechterungszuständen und Verwendungsstatus der Sekundärbatterie angeben, und Ereignissen, die in der Sekundärbatterie in der Vergangenheit aufgetreten sind, erhalten wird, wobei als Trainingsdaten die Informationen, die die vergangenen Verschlechterungszustände und Verwendungszustände der an der Benutzervorrichtung und/oder an anderen Benutzervorrichtungen angebrachten Sekundärbatterie angeben, und die Informationen, die die in der Sekundärbatterie in der Vergangenheit aufgetretenen Ereignisse angeben, verwendet werden;
eine Bestimmungseinheit eines detaillierten Verschlechterungszustands, die in einem Fall, in dem die Abweichungsbestimmungseinheit bestimmt, dass der jüngste Verschlechterungszustand von der Tendenz abweicht, Informationen über einen detaillierten Verschlechterungszustand, einschließlich Informationen, die das in der Sekundärbatterie auftretende Ereignis angeben, das durch die Ereignisschätzeinheit auf der Basis des Wertes des jüngsten Verschlechterungszustands und der Informationen zum Verwendungsstatus der Sekundärbatterie eingeschätzt wurde, bestimmt; und
eine Ausgabeeinheit, die den Wert des jüngsten Verschlechterungszustands, der von der Einheit zur Erkennung eines Verschlechterungszustands erkannt wurde, und die Informationen bezüglich des detaillierten Verschlechterungszustands, die von der Einheit zur Bestimmung eines detaillierten Verschlechterungszustands bestimmt wurden, ausgibt.

4. Zustandsausgabesystem nach einem der Ansprüche 1 bis 3, wobei
die Tendenzerfassungseinheit die Tendenz des Verschlechterungszustands der Sekundärbatterie auf Basis eines gleitenden Durchschnittswerts von Werten von Verschlechterungszuständen der Sekundärbatterie für einen vorgegebenen Zeitraum unter den Werten der vergangenen Verschlechterungszustände der Sekundärbatterie, die in der Speichereinheit gespeichert sind, erfasst, und
in einem Fall, in dem eine Differenz zwischen dem gleitenden Durchschnittswert der Werte der Verschlechterungszustände der Sekundärbatterie für den vorgegebenen Zeitraum und dem Wert des jüngsten Verschlechterungszustandes einem vorbestimmten Schwellenwert entspricht oder höher ist, die Einheit zur Bestimmung einer Abweichung bestimmt, dass der jüngste Verschlechterungszustand von der Tendenz abweicht.

5. Zustandsausgabesystem nach einem der Ansprüche 1 bis 4, wobei die Einheit zur Erkennung eines Verschlechterungszustands Informationen, die einen Wert des Innenwiderstands oder der Ladekapazität in einem anfänglichen Zustand der Sekundärbatterie angeben, und Informationen, die einen jüngsten Wert des Innenwiderstands oder der Ladekapazität der Sekundärbatterie angeben, basierend auf Informationen, die die jüngste Spannung, den jüngsten Strom und die jüngste Temperatur der Sekundärbatterie angeben, erfasst, um einen Wert eines Grads der Zunahme des Innenwiderstands oder einen Grad der verbleibenden Kapazität der Sekundärbatterie, der auf der Basis der Informationen bestimmt wurde, als einen Wert des Verschlechterungszustands der Sekundärbatterie zu erkennen.

6. Zustandsausgabesystem nach einem der Ansprüche 1 bis 5, ferner umfassend
eine Einheit zur Schätzung der verbleibenden Lebensdauer, die die verbleibende Lebensdauer als einen Zeitraum, bis die Sekundärbatterie einen vorbestimmten Verschlechterungszustand erreicht, schätzt, wobei
die Einheit zur Schätzung der verbleibenden Lebensdauer so konfiguriert ist, dass sie einen Wert des zukünftigen Innenwiderstands oder der zukünftigen Restkapazität der Sekundärbatterie aus der Tendenz des Verschlechterungszustands der Sekundärbatterie vorhersagt und als verbleibende Lebensdauer der Sekundärbatterie einen Zeitraum abschätzt, bis der vorhergesagte zukünftige Wert des Innenwiderstands oder der Ladekapazität der Sekundärbatterie eine vordefinierte Obergrenze des Werts des Innenwiderstands oder eine vordefinierte Untergrenze des Werts der Ladekapazität der Sekundärbatterie erreicht, und
die Ausgabeeinheit konfiguriert ist, Informationen auszugeben, die die verbleibende Lebensdauer angeben.

7. Zustandsausgabesystem nach Anspruch 2 oder Anspruch 3, des Weiteren umfassend
eine Einheit zur Erkennung eines Risikoniveaus, die sich auf Informationen bezieht, in denen das in der Sekundärbatterie auftretende Ereignis und ein Risikoniveau des Ereignisses in Verbindung miteinander aufgezeichnet werden, um das Risikoniveau des von der Ereigniseinschätzungseinheit eingeschätzten Ereignisses zu erkennen,
wobei die Einheit zur Bestimmung eines detaillierten Verschlechterungszustands die Informationen bezüglich des detaillierten Verschlechterungszustands auf Basis eines Inhalts des von der Ereigniseinschätzungseinheit eingeschätzten Ereignisses und des Risikoniveaus bestimmt.

8. Zustandsausgabesystem nach Anspruch 7, des Weiteren umfassend
eine Wartungstechniker-Vorrichtung, die von einem Wartungstechniker verwendet wird, der die Wartung der Sekundärbatterie durchführt,
wobei, wenn das von der Einheit zur Erkennung eines Risikoniveaus erkannte Risikoniveau eine vorgegebene Bedingung erfüllt, die Wartungstechniker-Vorrichtung Informationen ausgibt, die das Risikoniveau und den Inhalt des von der Ereigniseinschätzungseinheit eingeschätzten Ereignisses angeben.

## Revendications

1. Système de sortie d'état dans un système pour délivrer un état de détérioration d'une batterie secondaire montée sur un dispositif d'utilisateur utilisé par un utilisateur, comprenant :
une unité de stockage qui stocke des informations ;
une unité de reconnaissance d'état de détérioration qui quantifie un état de détérioration de la batterie secondaire sur la base d'informations indicatives d'une tension, d'un courant et d'une température de la batterie secondaire, reconnaît la valeur quantifiée comme une valeur de l'état de détérioration de la batterie secondaire, stocke la valeur de l'état de détérioration dans l'unité de stockage par ordre chronologique, et stocke des informations d'état d'utilisation, incluant des informations de position du dispositif d'utilisateur et indicatives de la manière selon laquelle la batterie secondaire a été utilisée par le passé ou jusqu'à présent, dans l'unité de stockage par ordre chronologique ;
une unité d'acquisition de tendance qui acquiert une tendance de l'état de détérioration de la batterie secondaire sur la base de valeurs d'états de détérioration de la batterie secondaire à une pluralité d'instants passés stockées dans l'unité de stockage ;
une unité de détermination d'écart qui détermine si un état de détérioration le plus récent s'écarte ou non de la tendance sur la base de la tendance de l'état de détérioration de la batterie secondaire acquise par l'unité d'acquisition de tendance et d'une valeur de l'état de détérioration le plus récent de la batterie secondaire reconnu par l'unité de reconnaissance d'état de détérioration ;
une unité de détermination d'état de détérioration détaillé qui, dans un cas où l'unité de détermination d'écart détermine que l'état de détérioration le plus récent s'écarte de la tendance, acquiert, à partir des informations d'état d'utilisation, des informations de caractéristiques géographiques comme informations indicatives de caractéristiques géographiques qui affectent l'état de détérioration de la batterie secondaire sur la base d'informations de position passées et/ou courantes du dispositif d'utilisateur pour déterminer, sur la base des informations de position et des informations de caractéristiques géographiques, des informations sur un état de détérioration détaillé incluant des informations sur des caractéristiques géographiques ayant affecté l'état de détérioration de la batterie secondaire et/ou des informations sur une réponse en fonction des caractéristiques géographiques à recommander pour éviter qu'il ne devienne un état de détérioration s'écartant de la tendance ; et
une unité de sortie qui délivre la valeur de l'état de détérioration le plus récent reconnu par l'unité de reconnaissance d'état de détérioration et les informations sur l'état de détérioration détaillé déterminé par l'unité de détermination d'état de détérioration détaillé

2. Système de sortie d'état dans un système pour délivrer un état de détérioration d'une batterie secondaire montée sur un dispositif d'utilisateur utilisé par un utilisateur, comprenant :
une unité de stockage qui stocke des informations ;
une unité de reconnaissance d'état de détérioration qui quantifie un état de détérioration de la batterie secondaire sur la base d'informations indicatives d'une tension, d'un courant et d'une température de la batterie secondaire, reconnaît la valeur quantifiée comme une valeur de l'état de détérioration de la batterie secondaire, et stocke la valeur de l'état de détérioration dans l'unité de stockage par ordre chronologique ;
une unité d'acquisition de tendance qui acquiert une tendance de l'état de détérioration de la batterie secondaire sur la base de valeurs d'états de détérioration de la batterie secondaire à une pluralité d'instants passés stockées dans l'unité de stockage ;
une unité de détermination d'écart qui détermine si un état de détérioration le plus récent s'écarte ou non de la tendance sur la base de la tendance de l'état de détérioration de la batterie secondaire acquise par l'unité d'acquisition de tendance et d'une valeur de l'état de détérioration le plus récent de la batterie secondaire reconnu par l'unité de reconnaissance d'état de détérioration ;
une unité d'estimation d'événement qui fait référence à des informations stockées dans lesquelles l'une quelconque d'informations indicatives de la tension, du courant et de la température de la batterie secondaire ou d'une combinaison de celles-ci est associée à un événement survenant dans la batterie secondaire pour estimer l'événement survenant dans la batterie secondaire sur la base de l'une quelconque des informations indicatives de la tension, du courant et de la température de la batterie secondaire ou de la combinaison de celles-ci ;
une unité de détermination d'état de détérioration détaillé qui, dans un cas où l'unité de détermination d'écart détermine que l'état de détérioration le plus récent s'écarte de la tendance, détermine des informations sur un état de détérioration détaillé incluant des informations indicatives de l'événement survenant dans la batterie secondaire estimé par l'unité d'estimation d'événement sur la base de l'une quelconque des informations indicatives de la tension, du courant et de la température de la batterie secondaire ou de la combinaison de celles-ci ; et
une unité de sortie qui délivre la valeur de l'état de détérioration le plus récent reconnu par l'unité de reconnaissance d'état de détérioration et les informations sur l'état de détérioration détaillé déterminé par l'unité de détermination d'état de détérioration détaillé.

3. Système de sortie d'état dans un système pour délivrer un état de détérioration d'une batterie secondaire montée sur un dispositif d'utilisateur utilisé par un utilisateur, comprenant :
une unité de stockage qui stocke des informations ;
une unité de reconnaissance d'état de détérioration qui quantifie un état de détérioration de la batterie secondaire sur la base d'informations indicatives d'une tension, d'un courant et d'une température de la batterie secondaire, reconnaît la valeur quantifiée comme une valeur de l'état de détérioration de la batterie secondaire, et stocke la valeur de l'état de détérioration dans l'unité de stockage par ordre chronologique ;
une unité d'acquisition de tendance qui acquiert une tendance de l'état de détérioration de la batterie secondaire sur la base de valeurs d'états de détérioration de la batterie secondaire à une pluralité d'instants passés stockées dans l'unité de stockage ;
une unité de détermination d'écart qui détermine si un état de détérioration le plus récent s'écarte ou non de la tendance sur la base de la tendance de l'état de détérioration de la batterie secondaire acquise par l'unité d'acquisition de tendance et d'une valeur de l'état de détérioration le plus récent de la batterie secondaire reconnu par l'unité de reconnaissance d'état de détérioration ;
une unité d'estimation d'événement qui estime un événement survenant dans la batterie secondaire à partir de la valeur de l'état de détérioration le plus récent de la batterie secondaire et d'informations d'état d'utilisation en utilisant un modèle prédictif avec la valeur de l'état de détérioration et les informations d'état d'utilisation de la batterie secondaire comme entrées et l'événement survenant dans la batterie secondaire comme sortie, où le modèle prédictif est obtenu par apprentissage automatique d'une corrélation entre des informations indicatives de valeurs d'états de détérioration passés et d'états d'utilisation de la batterie secondaire et des événements qui sont survenus dans la batterie secondaire par le passé en utilisant, comme données d'entraînement, les informations indicatives des états de détérioration passés et des états d'utilisation de la batterie secondaire montée sur le dispositif d'utilisateur et/ou d'autres dispositifs d'utilisateur et des informations indicatives des événements qui sont survenus dans la batterie secondaire par le passé ;
une unité de détermination d'état de détérioration détaillé qui, dans un cas où l'unité de détermination d'écart détermine que l'état de détérioration le plus récent s'écarte de la tendance, détermine des informations sur un état de détérioration détaillé incluant des informations indicatives de l'événement survenant dans la batterie secondaire estimé par l'unité d'estimation d'événement sur la base de la valeur de l'état de détérioration le plus récent et des informations d'état d'utilisation de la batterie secondaire ; et
une unité de sortie qui délivre la valeur de l'état de détérioration le plus récent reconnu par l'unité de reconnaissance d'état de détérioration et les informations sur l'état de détérioration détaillé déterminé par l'unité de détermination d'état de détérioration détaillé.

4. Système de sortie d'état selon l'une quelconque des revendications 1 à 3, dans lequel
l'unité d'acquisition de tendance acquiert la tendance de l'état de détérioration de la batterie secondaire sur la base d'une valeur de moyenne mobile de valeurs d'états de détérioration de la batterie secondaire pendant une période prédéterminée parmi des valeurs des états de détérioration passés de la batterie secondaire stockées dans l'unité de stockage, et
dans un cas où une différence entre la valeur de moyenne mobile des valeurs d'états de détérioration de la batterie secondaire pendant la période prédéterminée et la valeur de l'état de détérioration le plus récent est supérieure ou égale à une valeur de seuil prédéterminée, l'unité de détermination d'écart détermine que l'état de détérioration le plus récent s'écarte de la tendance.

5. Système de sortie d'état selon l'une quelconque des revendications 1 à 4, dans lequel l'unité de reconnaissance d'état de détérioration acquiert des informations indicatives d'une valeur de résistance interne ou de capacité de charge dans un état initial de la batterie secondaire, et des informations indicatives d'une valeur de résistance interne ou de capacité de charge la plus récente de la batterie secondaire sur la base d'informations indicatives de la tension, du courant et de la température les plus récentes de la batterie secondaire pour reconnaître une valeur d'un degré d'augmentation de résistance interne ou d'un degré de capacité restante de la batterie secondaire déterminé sur la base des informations comme une valeur de l'état de détérioration de la batterie secondaire.

6. Système de sortie d'état selon l'une quelconque des revendications 1 à 5, comprenant en outre :
une unité d'estimation de durée de vie restante qui estime une durée de vie restante comme une période jusqu'à ce que la batterie secondaire se trouve dans un état de détérioration prédéterminé, dans lequel
l'unité d'estimation de durée de vie restante est configurée pour prédire une valeur de résistance interne ou de capacité restante future de la batterie secondaire à partir de la tendance de l'état de détérioration de la batterie secondaire, et pour estimer, comme la durée de vie restante de la batterie secondaire, une période jusqu'à ce que la valeur de résistance interne ou de capacité de charge future prédite de la batterie secondaire atteigne une limite supérieure prédéfinie de la valeur de résistance interne ou une limite inférieure prédéfinie de la valeur de capacité de charge de la batterie secondaire, et
l'unité de sortie est configurée pour délivrer des informations indicatives de la durée de vie restante.

7. Système de sortie d'état selon la revendication 2 ou 3, comprenant en outre :
une unité de reconnaissance de niveau de risque qui fait référence à des informations dans lesquelles l'événement survenant dans la batterie secondaire et un niveau de risque de l'événement sont enregistrés en association l'un avec l'autre pour reconnaître le niveau de risque de l'événement estimé par l'unité d'estimation d'événement,
dans lequel l'unité de détermination d'état de détérioration détaillé détermine les informations sur l'état de détérioration détaillé sur la base d'un contenu de l'événement estimé par l'unité d'estimation d'événement et du niveau de risque.

8. Système de sortie d'état selon la revendication 7, comprenant en outre :
un dispositif d'ingénieur de maintenance utilisé par un ingénieur de maintenance qui réalise une maintenance de la batterie secondaire,
dans lequel, lorsque le niveau de risque reconnu par l'unité de reconnaissance de niveau de risque satisfait une condition prédéterminée, le dispositif d'ingénieur de maintenance délivre des informations indicatives du niveau de risque et du contenu de l'événement estimé par l'unité d'estimation d'événement.
